Europäisches Patentamt

European Patent Office

Office européen des brevets

(11) Publication number: **0 559 287 A1**

# EUROPEAN PATENT APPLICATION

(21) Application number: **93200590.3**

(51) Int. Cl.5: **G06F 11/26**

(22) Date of filing: **02.03.93**

(30) Priority: **03.03.92 NL 9200390**

(43) Date of publication of application:
**08.09.93 Bulletin 93/36**

(84) Designated Contracting States:
**AT BE CH DE DK ES FR GB GR IE IT LI LU NL PT SE**

(71) Applicant: **Koninklijke PTT Nederland N.V.**
**P.O. Box 95321**
**NL-2509 CH The Hague(NL)**

(72) Inventor: **Kwast, Erik**
**Boekhorststraat 165**
**NL-2512 CP The Hague(NL)**

(54) Method for the automatic generation of test sequences.

(57) Method for the automatic generation of test sequences for testing information-processing systems for conformance with a first specification relating to the dynamics of the signals to be exchanged, and with a second specification relating to the data contents of said signals. The first specification is stored in a first specification memory (2, 3), the second specification in a second specification memory (1). The second specification memory is used to derive first part test sequences (4, 5). Said first part test sequences are supplemented with second part test sequences, derived from the first specification memory, to give complete test sequences (6, 7).

FIG. 2

## A. BACKGROUND OF THE INVENTION

The invention relates to a method for the automatic generation of test sequences for testing information-processing systems for conformance with a first specification applying to such a system and relating to the prescribed dynamic behaviour of the signals to be mutually exchanged, such as can be specified, for example, in the form of a finite state machine, and a second specification relating to the prescribed data contents of the signals to be mutually exchanged.

A method of this type is suggested in reference 1. This suggests that message sequences (test sequences) be primarily derived from a first specification prescribing the dynamic behaviour of the information-processing system to be tested, specified, for example, in the form of a finite state machine (FSM). Said derivation results in a (large) series of empty test messages, i.e. messages without data contents. In order to arrive at complete test messages, which therefore include data contents, all the generated empty messages have to be filled with data. All the sequences then have to be checked for consistency with the data behaviour as prescribed in a second specification.

In practice, it is infeasible to carry out said method, because the number of test messages - which initially were data-less but were then filled with data parameters - is, in practice, very large. Testing for consistency with the specified data behaviour is found to require excessive amounts of computer time, and the percentage of test sequences, which comprises data combinations which are found to be acceptable on account of the data specification, is low.

## B. SUMMARY OF THE INVENTION

The invention is based on the finding mentioned in the previous paragraph and on the insight that the required test sequences - which must therefore satisfy both the first specification and the second specification - can still be generated by, in fact, inverting the sequential order of processing of the two specifications, namely by applying the data specification - which, in practice, apparently permits by far the fewest degrees of freedom - as a first "template" ("blueprint"), followed by the specification relating to the dynamic behaviour as a second "template". As a result, the number of primary (part) sequences, derived from the data specification is considerably smaller than the number of primary (part) test sequences in the known method, which, in practice, makes further processing easy to handle. In addition, the impact of the specification of the dynamic behaviour on the final test sequences is notably smaller (in the limiting sense, therefore) than the other way round, as suggested in the reference mentioned.

The invention thus provides a method for the automatic generation of test sequences for testing information-processing systems for conformance with a first specification applying to such a system and relating to the prescribed dynamic behaviour of the signals to be mutually exchanged, such as can be specified, for example, in the form of a finite state machine, and a second specification relating to the prescribed data contents of the signals to be mutually exchanged, which is characterised in that
- the said first specification is stored in computer-readable form in a first specification memory;
- the said second specification is likewise stored in computer-readable form in a second specification memory;
- first part test sequences are derived from the second specification memory;
- those first part test sequences derived from the second specification memory are supplemented to complete test sequences, with second part test sequences, which are derived from the first specification memory.

## C. REFERENCES

[1] Kwast, E.; Towards automatic test generation for protocol aspects; Proc. 11th Int. IFIP WG6.1 Symp. Protocol Spec., Testing and Verification, Stockholm, June 1991, p. 312-327
[2] US Patent 4692921 [AT&T]

## D. ILLUSTRATIVE EMBODIMENT

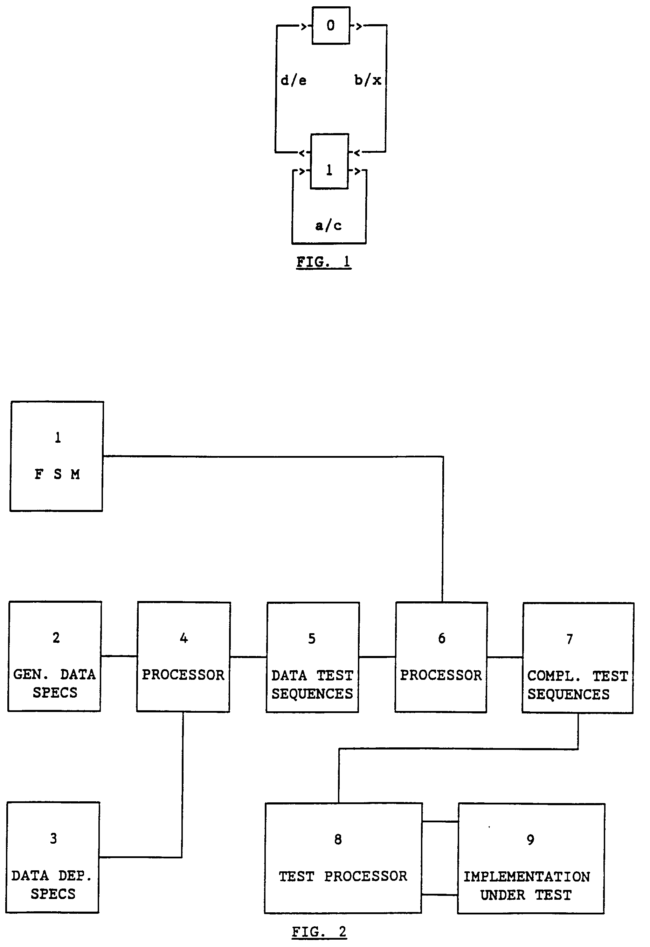

As an example of the computation of test sequences with the aid of the method according to the invention, use is made of a protocol whose dynamic behaviour is specified by an FSM (finite state machine) as detected in Figure 1.

The functioning of an FSM of this type is deemed to be known and is well explained, inter alia, in US Patent 4692921. If, from the start state 0, a system specified by the FSM (for example a VLSI IC, a PABX, a communication system) is given an input signal b, the system produces an output signal x and adopts a state 1. If thereafter a signal a is again presented, the system reacts by emitting a signal c and remains in state 1. If, however, a signal d is presented, the system emits a signal e and ends up (again) in state 0. Obviously, this is an example of a very simple system. In practice it is possible to specify very complex systems in this manner.

Apart from the dynamic behaviour, i.e. the state transitions to be effected by input signals and/or the output signals to be emitted, the contents of the signals are generally also specified in more detail, in particular the values which parameters associated with signals of this type may take, by themselves and in connection with each other. A specification of the parameters associated with the signals occurring in the FSM of Figure 1 is given in Table 1. It relates to the specification of the parameter values by themselves.

| SIGNAL | PARAMETER NAME | PERMITTED PARAMETER VALUE |
|---|---|---|
| a b c d e x | p q | 0 or 1 or 2 or 3 TRUE or FALSE |

Table 1

Table 2 gives the specification of the parameter values with respect to their connection with each other, in other words their "dependence rules".

| DEPENDENCE RULE | CONTENTS |
|---|---|
| R1 | IF (a AND b) THEN c(p=0) |
| R2 | IF c(p=0 OR 1 OR 2) THEN c(p=p+1) |
| R3 | IF c(p=2) THEN d(q=TRUE) |

Table 2

The significance of the contents of Table 2 is illustrated in Table 3.

| DEPENDENCE RULE | SIGNIFICANCE |
|---|---|
| R1 | Upon reception of signal a and signal b, parameter p of signal c acquires the value 0 |
| R2 | If parameter p of signal c has the value 0 or 1 or 2, then that parameter value is increased by the value 1 |
| R3 | If parameter value p of signal 2 is equal to 2, then parameter q of signal d acquires the value TRUE |

<u>Table 3</u>

As a further example, the process for deriving the part test sequence (or sequences) for testing (an implementation) for consistency with the general specification according to Table 1 and with the dependence rule R3 will be dealt with. This derivation takes place according to the steps indicated in Table 4.

| Step 1 | Rule R3 gives as an entry condition that parameter p must have the value 2, as a consequence of which parameter q of signal d must take the value TRUE. |
|---|---|
| Step 2 | Rule R2 states that p acquires the value 2 by raising a previous signal c by the value 1, p having had the value 1; |
| Step 3 | Rule R2 also states that p acquires the value 2 by raising a previous signal c by the value 1, p having had the value 0; |
| Step 4 | Rule R1 states that a signal c, parameter p having the value 0, is produced as a consequence of having received both signal a and signal b (for which no parameter values are specified). |

<u>Table 4</u>

Working back, it is therefore necessary, so that parameter p of signal c takes the value 2, in order to satisfy the entry state of rule R3, for the signals a and b to be detected first [1'], followed by the appearance of signal c to appear, with a parameter value for p equal to 0 [2']. It is then necessary to detect whether signal c appears once more, but then with a parameter value for p equal to 1 [3'], and finally once more with a value for p equal to 2 [4']. Only then is it possible to detect whether signal d appears, the parameter value for q being equal to TRUE [5']. Table 5 illustrates these steps in abbreviated form.

4

| Step 1' | Detect signal a and signal b |
|---|---|
| Step 2' | Detect signal c with parameter p=0 |
| Step 3' | Detect signal c with parameter p=1 |
| Step 4' | Detect signal c with parameter p=2 |
| Step 5' | Detect signal d with parameter TRUE |

<u>Table 5</u>

On the basis of the general specification (Table 1) and the dependence specification (Table 2), relating to the data contents of the signals (the parameters), it is therefore possible to form the following part test sequence, corresponding to the steps 1' - 5' from Table 5.:

$$\{a\ AND\ b\} - \{c(p=0)\} - \{c(p=1)\} - \{c(p=2)\} - \{d(q=TRUE)\}$$

$$========>$$

This part test sequence only is the result of Table 1 and Table 2. To achieve the complete test sequence for the system to be tested, of which the actual, dynamic behaviour is controlled in conformance with the FSM model shown in Figure 1, the part test sequence must be made consistent, i.e. be supplemented with that specification. It can be seen from the FSM specification that signal b must first be presented to the system as an input signal, before signal a can be presented (successfully) thereto. The system ends up in stage 1 from stage 0 and reacts by emitting the output signals x and c. The value of that c signal can be detected, and the parameter p should, as the part test sequence above shows, have the value 0. In order to generate subsequently, as prescribed by the part test sequence, a c signal (as an output signal) twice more, an a signal must be presented twice more. If the system functions properly, the parameter p of the signal is first (in conformance with dependence rule 2) raised to the value 1 and then to the value 2. The system in this process has always returned to stage 1. Thereafter, signal d can be presented to the system as the input signal, parameter q having to have the value TRUE. Thus the part test sequence above is completed as follows:

$$\{b\}-\{x\}-\{a\}-\{c(p=0)\}-\{a\}-\{c(p=1)\}-\{a\}-\{c(p=2)\}-\{d(q=TRUE)\}-\{e\}$$

$$========>$$

It is pointed out that, in practice, the specifications, i.e. those relating to the dynamic behaviour and those relating to the data contents, are, of course, considerably more complex than the specifications illustrated hereinabove to illustrate the operation of the invention. In practice, it has surprisingly been found in this context that, if part test sequences are first derived from the data contents specification, which are then complemented (or modified in another way) with the necessary specification elements from the specification of the dynamic behaviour, the computation time is considerably less than when starting with the dynamic behaviour of the system. In that case, a large excess of part test sequences is produced, which afterwards has to be reduced again drastically with reference to the data contents specification. In the latter case, the computation time would have to be expressed in days (!) while, by contrast, when the method according to the invention is followed, the computation time can be expressed in minutes.

Figure 2 shows a configuration for the automatic derivation of test sequences according to the abovementioned method. The specification of the dynamic behaviour of a system to be tested, as shown in Figure 1 in the form of an FSM, is stored - in a computer-readable form -in a memory 1. The general specification of the data contents, the parameters, of the signals to be exchanged by the system, as shown in Table 1, is stored, in computer-readable form, in a memory 2, while the specification of the mutual dependences of the signal parameters, as depicted in Table 2, likewise in computer-readable form, is stored in a memory 3. A processor 4 forms a part test sequence, in the manner indicated by Tables 4 and 5, and stores it in a memory 5. With reference to the specification stored in the memory 1, a processor 6 then supplements the part test sequences from memory 5 with the elements from memory 1 which are necessary for actually carrying out the test, resulting in a complete test sequence as depicted above, which is stored in a memory 7. The test sequence thus generated is subsequently fed to a test processor 8 which carries out the actual testing of an IUT "implementation under test" 9 for conformance with the specifications. To this end, in conformance with the test sequence, a number of input signals are presented to the IUT 9 and the output signals generated by the IUT 9 are received and compared with the specified output signals, including the parameter values of those output signals. The exchanged signals are depicted below in Table 6.

| Transmitted input signal | Output signal to be received |
|---|---|
| {b} | {x} |
| {a} | {c(p=0) } |
| {a} | {c(p=1) } |
| {a} | {c(p=2) } |
| {d(q=TRUE) } | {e} |

<u>Table 6</u>

In the above, by way of example, the derivation of only one test sequence was followed. It will be evident that in practice, when using considerably more extensive specifications, many more "test objectives" (in the example above, checking conformance with R3) will be produced, as a result of which a larger number of test sequences will also be generated.

**Claims**

1. Method for the automatic generation of test sequences for testing information-processing systems for conformance with a first specification applying to such system and relating to the prescribed dynamic behaviour of the signals to be mutually exchanged, such as can be specified, for example, in the form of a finite state machine, and a second specification relating to the prescribed data contents of the signals to be mutually exchanged,
   CHARACTERISED IN THAT
   - said first specification is stored in computer-readable form in a first specification memory (1);
   - said second specification is likewise stored in computer-readable form in a second specification memory (2, 3);
   - first part test sequences are derived from the second specification memory;
   - the first part test sequences derived from the second specification memory are supplemented to complete test sequences, with second part test sequences, which are derived from the first specification memory.

FIG. 1

FIG. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A,D | US-A-4 692 921 (DAHBURA ET AL.) <br> * claim 4 * <br> --- | 1 | G06F11/26 |
| A | US-A-4 991 176 (DAHBURA ET AL.) <br> * claim * <br> --- | 1 | |
| A | IBM TECHNICAL DISCLOSURE BULLETIN. <br> vol. 33, no. 10A, March 1991, NEW YORK US <br> pages 114 - 126 'Critical path tracing for sequential circuits' <br> * page 119, line 6 - page 121, line 8 * <br> ----- | 1 | |
| | | | **TECHNICAL FIELDS SEARCHED (Int. Cl.5 )** <br><br> G06F |

The present search report has been drawn up for all claims

| Place of search | Date of completion of the search | Examiner |
|---|---|---|
| THE HAGUE | 10 JUNE 1993 | Guido Corremans |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.........................................................................................
& : member of the same patent family, corresponding
    document

EPO FORM 1503 03.82 (P0401)